# EUROPEAN PATENT APPLICATION

(11) **EP 1 246 364 A1**
(43) Date of publication of application: **02.10.2002**
(21) Application number: 01107619.7
(22) Date of filing: 27.03.2001
(51) Int. Cl.: H03K 17/94, H04B 1/08, G06F 3/023

(54) **Method to provide a non-visual control functionality for a device and corresponding device interface**

(71) Applicant: Sony International (Europe) GmbH, 10785 Berlin (DE)
(72) Inventor: Hagg, Wilhelm, Dr., Advanced Techn.Cent. Stuttgart, 70327 Stuttgart (DE)
(74) Representative: Müller - Hoffmann & Partner

(57) **Abstract**

A device interface, comprising at least one input button (3 - 7) provided with a selection function and an activation function, comprises the functionality that upon actuation of said selection function of an input button (3 - 7) a functionality of said input button (3 - 7) is output and upon actuation of said control function of an input button (3 - 7) the functionality of said input button is caused to be carried out.

## Description

The present invention relates to a method to provide a non-visual control functionality for a device and a corresponding device interface.

Device control of today's electronic devices becomes more and more complex so that a user quite often has the burden to remember a confusing operating functionality. Usually, a device interface comprises a plurality of push buttons each of which shows one or more functions to control the device. All functions are normally indicated on the button or in the vicinity thereof so that the user can identify the correct button for the wanted corresponding functionality.

However, in some situations it is difficult or even impossible to control a complex device with a couple of buttons, since the user is not able or allowed to focus his/her eyes on the device in order to select the desired button to push. While driving a car for example, the driver should focus the eyes on the road for security reasons. Therefore, it is difficult or dangerous to control for example an audio device or a navigation system with a couple of buttons.

To overcome this problem, it is proposed to use speech control. In a device equipped therewith a speech recognition system tries to understand and to interpret the spoken commands of a user. Those systems are usually expensive, since a serious amount of computing recources is required for the speech recognition. Furthermore, it is very uncomfortable for other persons when the user of such a system is talking to the device all the time.

Therefore, it is the object underlying the present invention to provide an alternative method for a non-visual control functionality for a device and a corresponding device interface.

According to the present invention, this object is solved by a device interface according to independent claim 1 and a method to provide a non-visual control functionality for a device according to independent claim 9. Preferred embodiments thereof are respectively defined in the respectively following dependent claims.

The device interface according to the present invention which comprises at least one input button provided with a selection function and an activation function has the functionallity that upon actuation of said selection function of an input button a functionality of said input button is output and upon actuation of said control function of an input button the functionality of said input button is caused to be carried out.

The method to provide a non-visual control functionality for a device via a device interface comprising at least one input button provided with a selection function and an activation function according to the present invention comprises the steps of outputting a functionality of an input button upon actuation of said selection function of said input button and causing the functionality of an input button to be carried out upon actuation of said control function of said input button.

The functionality of an input button in this context means the function which is carried out upon actuation of the input button in the "classical" sense, e.g. the functionality of a "Switch on" button of a device is to switch the device on in case the button is actuated.

Therefore, the present invention allows the control of a device without focussing the eyes on the device, since a user can first actuate the selection function of an input button so that the functionality of said input button which selection function was actuated is output to the user, and after the user recognized that the wanted input button was selected it is possible to actuate the control function of said input button so that the functionality of said input button is caused to be carried out. Such a provision of input buttons with a double actuation functionality as described above enables the design of a non-visual controllable device interface without the provision for an expensive speech recognition module for speech command control and without the need to input speech commands which may be uncomfortable for other persons.

According to the present invention the functionality of said input button might be caused to be carried out e.g. by issuing a command which corresponds to the functionality of said input button from said device interface to a controlable device to which the device interface relates.

According to a preferred embodiment of the present invention said selection function is actuatable by touching an input button and said activation function is actuatable by pressing an input button.

In this way a very easy to perform two step user action might be performed when not knowing the functionality of the device interface, i.e. an input button is first touched so that the functionality is output to the user and in case this is the wanted functionality the user then just keeps his/her finger on the button and depresses it. Furthermore, in case the user exactly knows the functionality, the immediate depressing of the button results in an immediate causing of the performance of the control function without first outputting the functionality assigned to the button to the user so that the device interface does not show the drawback that always an output of the functionality of an input button is provided in case an input button is actuated.

Alternatively or additionally said selection function is actuatable by touching an input button for a predetermined time and said activation function is actuatable by touching an input button for a time longer than said predetermined time.

Further alternatively or additionally said selection function is actuatable by approaching to an input button and said activation function is actuatable by touching an input button.

Still further alternatively or additionally said selection function is actuatable by placing a cursor over an input button and said activation function is actuatable by actuating a general confirmaton button. In this case a general confirmaton button might be comparable to the return key of a computer system.

According to a further preferred embodiment a functionality of an input button is output acoustically and/or optically and/or tactile.

According to a still further preferred embodiment an input button shows a changing functionality depending on the state on the controllable device.

According to a still further preferred embodiment an input button shows a changing functionality depending on the time the selection function in actuated.

Of course, all of the above described preferred embodiments might be combined as desired or required.

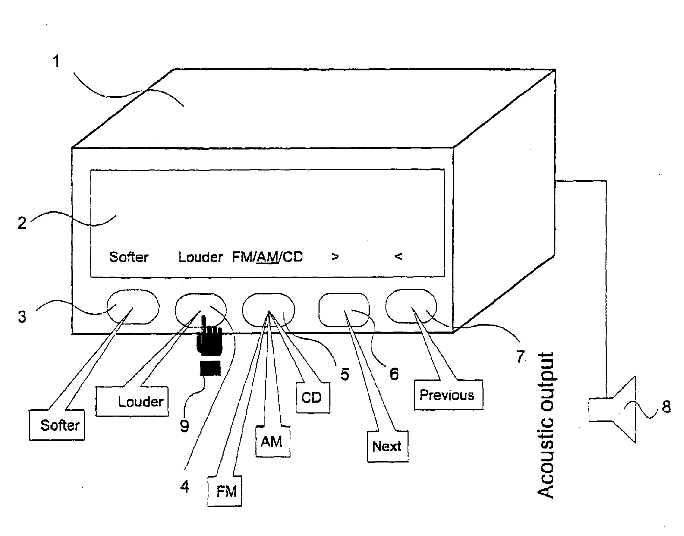

Further objects, advantages and features of the present invention will be better understood from the following detailed description of an exemplary embodiment thereof taken in conjunction with the accompanying Fig. 1, which shows a radio receiver comprising an interface according to an embodiment of the invention.

The shown receiver 1 comprises as an interface a display 2, five touch sensitive buttons 3 to 7 as input buttons which release different actions for touching and pressing a button, and at least one speaker 8.

According to this exemplary embodiment pressing a button 3 to 7 causes the corresponding control function to be carried out, while just touching a button 3 to 7 will cause some acoustic output describing the control function assigned to the button. This acoustic output via the speaker 8 is used by the user to navigate with his/her finger 9 among the five buttons 3 to 7 on the receiver 1 in order to select the desired control function. Therefore, the eyes of the controlling person are not required to focus on the receiver 1.

As mentioned above, the action taken in touching a button may vary in a wide range. The basic action in this exemplary embodiment is of course the acoustic output of a short text string describing the control function, as "Louder, "Smoother", "Station SWR 3" and so on. Optionally, acoustic samples describing the control function as a radio station jingle for example could be used. Furthermore, non-acoustic actions may be used, e.g. switching on a lamp of specific color which may be recognized by the user without changing the focus of his/her eyes or the projection of a textual description of the control function into the field of view of the user so that he/she can read the functionality of the touched button 3 to 7 without changing the angle of view and the focus.

Furthermore, as also mentioned above, a small time delay may be introduced for the action taken on touching a button. This will enable to control the device without any (acoustic) output if the user exceptionally has focused his/her eyes on the device or knows the functionality of the actuated input button 3 to 7 without needing to observe the device interface.

As further mentioned in the general description of the invention above, alternatively or additionally to the keys on a device also other input devices such as a touchpad or a joystick in conjunction with a push button which serves as a general confirmation button (similar to the return key of a PC) may be used. In that case the position on the touchpad or the joystick position is used for the selection of a control function. The corresponding acoustic output occurs immediately after a new control function is targeted by the device and the control function is performed when the button is pressed.

The proposed method is especially useful for so-called software keys, where the control function of a particular button depends on the actual state of the input device and is therefore subject to change. Usually, the control function is indicated on a display in the vicinity of the button, e.g. beneath or above the button. With the proposed method it is easy to navigate within a hierarchical structure of control functionality provided by a device.

Optionally, the control function of a key may change over time while the user is touching a button. This will be useful for example for the input of a digit. While the user touch the input button, the acoustic output counts the digits from 0 to 9 and the user selects the corresponding digit upon reaching the desired choice by pushing the button.

Fig. 1 also illustrates this principle. The five buttons 3 to 7 of the receiver 1 are software buttons, e. g. the control action of a button 3 to 7 depends on the state of the receiver 1. The respective control function/s of a button 3 to 7 is/are shown in the display 2 above the button. In the shown state of the receiver 1 the outermost left button 3 is related to the control function "Softer", i.e. to turn the output volume of the receiver 1 down. The second left button 4 is related to the control function "Louder", i.e. to turn the output volume of the receiver 1 up. The middle button 5 is related to the control function "FM/AM/CD", i.e. to select one of the input sources FM radio, AM radio, and CD to be output by the receiver. The second right button 5 is related to the control function "Next", e.g. to tune radio reception to the next station or to jump to the next track on a CD. The outermost right button 6 is related to the control function "Previous", e.g. to tune radio reception to the previous station or to jump to the previous track on a CD. All these control functions are also shown on the display 2, respectively directly above the control button 3 to 7 to which they relate.

Touching one of the buttons 3 to 7 with the finger 9, which is illustrated by the hand symbol, e.g. the "Louder" button, i.e. the second left button 4, leads to the issuing of the corresponding acoustic output describing the control function via the speaker 8, e.g. the corresponding text "louder" is issued via the loudspeaker 8 or another sound system to which the receiver is connected, e.g. the soundsystem via which the music output of the receiver 1 is performed. Pushing the second left button 4 will increase the volume.

For the "FM/AM/CD" button, i.e. the middle button 5 the control action changes over time and the corresponding control function strings "FM", "AM" and "CD" for input source selection are issued in a sequence over time to indicate the current control function. Pushing the middle button 4 directly after the respective acoustic output will then select the corresponding control function.

## Claims

1. Device interface, comprising at least one input button provided with a selection function and an activation function, **characterized in that** upon actuation of said selection function of an input button a functionality of said input button is output and upon actuation of said control function of an input button the functionality of said input button is caused to be carried out.

2. Device interface according to claim 1, **characterized in that** said selection function is actuatable by touching an input button and said activation function is actuatable by pressing an input button.

3. Device interface according to claim 1, **characterized in that** said selection function is actuatable by touching an input button for a predetermined time and said activation function is actuatable by touching an input button for a time longer than said predetermined time.

4. Device interface according to claim 1, **characterized in that** said selection function is actuatable by approaching to an input button and said activation function is actuatable by touching an input button.

5. Device interface according to claim 1, **characterized in that** said selection function is actuatable by placing a cursor over an input button and said activation function is actuatable by actuating a general confirmaton button.

6. Device interface according to anyone of the preceding claims, **characterized in that** a functionality of an input button is output acoustically and/or opically and/or tactile.

7. Device interface according to anyone of the preceding claims, **characterized in that** an input button shows a changing functionality depending on the state on the controllable device.

8. Device interface according to anyone of the preceding claims, **characterized in that** an input button shows a changing functionality depending on the time the selection function in actuated.

9. Method to provide a non-visual control functionality for a device via a device interface comprising at least one input button provided with a selection function and an activation function, **characterized by** outputting a functionality of an input button upon actuation of said selection function of said input button and causing the functionality of an input button to be carried out upon actuation of said control function of said input button.

10. Method according to claim 9, **characterized in that** said selection function is actuatable by touching an input button and said activation function is actuatable by pressing an input button.

11. Method according to claim 9, **characterized in that** said selection function is actuatable by touching an input button for a predetermined time and said activation function is actuatable by touching an input button for a time longer than said predetermined time.

12. Method according to claim 9, **characterized in that** said selection function is actuatable by approaching to an input button and said activation function is actuatable by touching an input button.

13. Method according to claim 9, **characterized in that** said selection function is actuatable by placing a cursor over an input button and said activation function is actuatable by actuating a general confirmaton button.

14. Method according to anyone of the preceding claims, **characterized in that** said functionality of an input button is output acoustically and/or opically and/or tactile.

15. Method according to anyone of the preceding claims, **characterized in that** an input button shows a changing functionality depending on the state on the controllable device.

16. Method according to anyone of the preceding claims, **characterized in that** an input button shows a changing functionality depending on the time the selection function in actuated.
